# EUROPÄISCHE PATENTSCHRIFT

(11) **EP 2 262 016 B1**
(45) Veröffentlichungstag und Bekanntmachung des Hinweises auf die Patenterteilung: **08.05.2019**
(21) Anmeldenummer: 10177356.2
(22) Anmeldetag: 27.10.2004
(51) Int. Cl.: H01L 33/00, H01L 33/46, H01L 33/62, H01L 31/0203

(54) **Kostengünstige, miniaturisierte Aufbau- und Verbindungstechnik für LEDs und andere optoelektronische Module**
Cost-effective miniaturised construction and connection technology for LEDs and other optoelectronic modules
Technique de montage et de liaison miniaturisée à bas coût pour DEL et autres modules optoélectroniques

(30) Priorität: 17.11.2003 DE 10353679
(43) Veröffentlichungstag der Anmeldung: 15.12.2010
(62) Teilanmeldung aus: 04791319.9
(73) Patentinhaber: OSRAM Opto Semiconductors GmbH, 93055 Regensburg (DE)
(72) Erfinder: Günther, Ewald Karl Michael, 93128, Regenstauf (DE); Sorg, Jörg Erich, 93053, Regensburg (DE); Weidner, Karl, 81245, München (DE); Zapf, Jörg, 81927, München (DE)
(74) Vertreter: Epping - Hermann - Fischer

(56) Entgegenhaltungen:
- WO-A2-2005/043631
- DE-A1- 4 228 274
- DE-A1- 19 901 918
- JP-A- S58 130 375
- JP-A- 2003 218 392
- US-A1- 2002 137 245
- US-A1- 2003 160 258
- US-B1- 6 281 524

## Beschreibung

Bei der Herstellung von einzelnen LEDs und Beleuchtungsmodulen (Compact Light Sources) kommen als elektrische Kontaktiertechniken zwischen Chip und Substrat überwiegend Drahtbonden und Löten bzw. eine Chipmontage mit Leitkleber zum Einsatz. Auf diese Weise entstehen bestückbare Bauelemente oder auch LED-Arrays für Beleuchtungsmodule. Der übliche Aufbauprozess ist wie folgt:
- Diebonden: Platzieren des oder der Chips in einem gefüllten Leitkleber (Kleben) und Aushärten des Klebers oder
- Montage des Chips mit Hilfe eines Lotes, unter Temperatur und möglicherweise Druck (Löten/Legieren),
- Wirebond: Elektrischer Anschluss des Chips durch Drahtkontaktieren,
- Einkapselung des Chips mit transparentem Material (Epoxi, Silikon, Acrylat, Polyurethan und andere Polymere) durch Gießtechnik oder Spritztechnik,
- Vereinzeln der Nutzen durch Sägen, Wasserstrahlschneiden oder Lasertrennen.

Die Druckschrift DE 4228274 A1 beschreibt ein Verfahren, bei dem optoelektronische Bauelemente auf einem Träger angeordnet werden und eine elektrisch isolierende Kunststoffschicht auf die Bauelemente und auf den Träger aufgebracht wird, woraufhin Kontaktlöcher im Bereich von Anschlussflächen des Trägers und der Bauelemente in die Kunststoffschicht eingebracht werden. Elektrische Verbindungen werden dann in Form von Durchkontaktierungen und Leiterbahnen in den Kontaktlöchern und auf der Oberfläche der Kunststoffschicht hergestellt.

Die Druckschrift JP 2003-218392 A beschreibt ein Display, das einen Trägerkörper und darauf angeordnete Bauelemente aufweist, wobei die Bauelemente jeweils auf einer Strählungsaustrittsseite des Displays mit einer elektrisch isolierenden transparenten Schicht bedeckt sind. Auf der elektrisch isolierenden Schicht, die Öffnungen zur elektrischen Kontaktierung der Bauelemente aufweist, sind elektrische Leiterbahnen angeordnet, die aus einem Metall gebildet und so strahlungsreflektierend ausgeführt sein können.

Im Zuge der Miniaturisierung werden am Markt immer geringere Bauteilhöhen angefragt. Dabei müssen die Produkte kostengünstig sein und eine ausreichende Zuverlässigkeit bieten. Im Fall von Chip-Arrays werden sogar sehr hohe Zuverlässigkeiten gefordert. Darüber hinaus sollte die Verbindungstechnik eine hohe Flexibilität bieten, um schnell, flexibel und kostengünstig auf Designänderungen reagieren zu können.

Davon ausgehend liegt der Erfindung die Aufgabe zugrunde, Module mit einem Substrat und optoelektronischen Bauelementen sowie Verfahren zu deren Herstellung anzugeben, die diesen Anforderungen gerecht werden.

Diese Aufgabe wird durch die in den unabhängigen Ansprüchen angegebenen Erfindungen gelöst. Vorteilhafte Ausgestaltungen ergeben sich aus den abhängigen Ansprüchen.

Dementsprechend weist ein Substrat ein optoelektronisches Bauelement auf, das planar elektrisch kontaktiert ist. Die Kontaktierung erfolgt also nicht mehr durch dicke, gegebenenfalls im Abstand von Substrat und Bauelement geführte Drähte, sondern durch eine planare, flache, ebene Leitstruktur etwa in Form einer Kupferschicht.

Durch die planare elektrische Kontaktierung ergibt sich eine besonders geringe Bauhöhe des Moduls aus Substrat und optoelektronischem Bauelement.

Das optoelektronische Bauelement kann beispielsweise mit anderen optoelektronischen Bauelementen auf dem Substrat kontaktiert sein. Das optoelektronische Bauelement ist mit Leiterbahnen des Substrats planar kontaktiert.

Um die planare Kontaktierung in einem möglichst geringem Abstand vom Substrat und/oder optoelektronischen Bauelement zu führen, sind das Substrat und/oder das optoelektronische Bauelement zumindest teilweise mit einer isolierenden Schicht versehen, auf der zur planaren Kontaktierung des optoelektronischen Bauelements die planare Leitstruktur angeordnet ist.

Die isolierende Schicht ist durch eine Folie, Lack und/oder eine Polymerschicht gebildet. Eine Folie wird auflaminiert. Eine Strukturierung der isolierenden Schicht kann beispielsweise mittels Laser, (Plasma-)Ätzen, Inkjet und/oder Fotostrukturierung erfolgen. Als Polymer kann insbesondere Parylene verwendet werden.

Dem optoelektronischen Bauelement sollte eine Lichtwechselwirkung mit der Umgebung möglich sein.

In der isolierenden Schicht ist hierzu im Bereich der Lichtaus- und/oder -eintrittsöffnung des optoelektronischen Bauelements ein Fenster geöffnet. Das Fenster kann, beispielsweise wenn die isolierende Schicht durch eine Folie gebildet wird, bereits vor dem Aufbringen der Schicht in dieser vorhanden sein. Alternativ lässt es sich aber auch nach dem Aufbringen der Schicht durch entsprechendes Strukturieren der Schicht mittels der oben genannten Vorgehensweisen öffnen.

Ein solches Fenster ist vorzugsweise in der isolierenden Schicht auch im Bereich einer oder mehrerer elektrischer Kontaktstellen des optoelektronischen Bauelementes vorgesehen. Durch das Fenster kann dann die planare Leitstruktur zur Kontaktstelle des optoelektronischen Bauelements geführt sein.

Die isolierende Schicht und die planare Leitstruktur verdecken alle Lichtaus- und/oder -eintrittsöffnung des optoelektronischen Bauelements an denen ein Lichtaustritt nicht gewünscht ist. Dazu ist die planare Leitstruktur reflektierend ausgeführt, so dass Licht in das optoelektronische Bauelement zurückreflektiert wird und dieses an einer anderen Lichtaustrittsöffnung verlassen kann. So lässt sich über die planare Kontaktierung zusätzlich eine Lichtführung erzielen.

Das optoelektronische Bauelement ist beispielsweise eine LED, insbesondere eine OLED, und/oder ein fotovoltaisches Bauelement. Als Substrat können eine Leiterplatte, eine Keramik, eine, insbesondere beidseitig mit Kupfer kaschierte, Flex, ein beispielsweise gestanzter oder geätzter Leadframe oder ein Schichtaufbau zum Einsatz kommen, wie er beispielsweise bei der Herstellung von Chipkarten oder flexiblen Schaltkreisen verwendet wird.

Vorzugsweise beträgt die Höhe des Erzeugnisses mit Substrat und optoelektronischem Bauelement weniger als 0,4 mm.

In einem Verfahren zum Herstellen eines Erzeugnisses aufweisend ein Substrat mit einem optoelektronischen Bauelement wird das optoelektronische Bauelement planar elektrisch kontaktiert. Vorteilhafte Ausgestaltungen des Verfahrens ergeben sich analog zu den vorteilhaften Ausgestaltungen des Erzeugnisses und umgekehrt.

Weitere Vorteile und Merkmale der Erfindung lassen sich der Beschreibung von Ausführungsbeispielen anhand der Zeichnung entnehmen. Dabei zeigt:
- Figur 1: einen Schnitt durch ein Erzeugnis aufweisend ein Substrat mit einem planar kontaktierten optoelektronischen Bauelement;
- Figur 2: einen Schnitt durch ein nicht erfindungsgemäßes Erzeugnis aufweisend ein Substrat mit einem planar kontaktierten optoelektronischen Bauelement;
- Figur 3: einen Vergleich zwischen dem planar und einem herkömmlich kontaktierten optoelektronischen Bauelement in der Draufsicht und
- Figur 4: einen Vergleich zwischen dem planar und dem herkömmlich kontaktierten optoelektronischen Bauelement bezüglich des Lichtausfalls.

Zunächst sollen einige Grundzüge der Aufbau- und Verbindungstechnik dargestellt werden.

Eines oder mehrere optoelektronische Bauelemente in Form von Chips werden durch Kleben oder Löten auf einem Substrat fixiert. Die elektrische Anbindung von Kontaktstellen in Form von Kontaktpads auf der Oberseite des optoelektronischen Bauelements erfolgt nun durch ein planares Kontaktierverfahren. Dieses kann zum Beispiel auf dem Auflaminieren einer elektrisch isolierenden Folie und der Kontaktierung durch planare Leitstrukturen in Form von Metallstrukturen auf dieser Folie basieren. Statt in Form einer isolierenden Folie kann eine isolierende Schicht allerdings auch durch andere Verfahren erzeugt werden, wie beispielsweise Lackieren, Aufdampfen oder Drucken.

Zur isolierenden Schicht in Form von Isolierfolie:
- Aufbringen zum Beispiel durch isostatisches Laminieren in einem Autoklaven oder durch Verwendung eines Hot-Roll-Laminators oder in einer Vakuum-Heißpresse.
- Die Folie kann im Wellenlängenbereich des vom optoelektronischen Bauelement emittierten oder absorbierten Lichts transparent sein. Dann ist kein partielles Entfernen der Folie notwendig. Die Folie kann dann auch die Schutzfunktion des Clear-Mold-Compounds mit übernehmen.
- Falls die Folie nicht ausreichend transparent ist, kann sie so strukturiert werden, dass je nach LED-Typ der Lichtaustritt an den Chipflanken und/oder an der Chipoberseite maximiert wird. Dies kann beispielsweise durch eine Laserablation flexibel und unabhängig von der Topografie erfolgen.
- Durch geeignete Laminierverfahren kann erreicht werden, dass die Isolierfolie die Chipoberfläche nachbildet. Damit kann erreicht werden, dass auch an den Kanten und in den Eckbereichen die volle Isolierfunktion zur Erhöhung der Zuverlässigkeit gegeben ist.

Zur Kontaktierung durch planare Leitstrukturen in Form von Metallstrukturen gibt es verschiedene Möglichkeiten:
- Elektrische Anbindung über einen geeigneten Metallisierungsprozess, zum Beispiel Aufbringen einer dünnen Startschicht durch Sputtern oder Aufdampfen, anschließend selektive Verstärkung durch stromlose oder galvanische Abscheidung zum Beispiel von Kupfer.
- Die Isolierfolie ist elektrisch leitfähig beschichtet, zum Beispiel durch Aufkaschieren einer Metallfolie. Diese Metallfolie wird nun vor oder nach dem Laminierprozess strukturiert. Die Verbindung zwischen Chip und Metallstruktur kann bei erhöhten, besonders rauen Bumps auf den Chip-Pads durch mechanisches Verpressen erfolgen oder auch durch partielle galvanische oder stromlose Abscheidung. Hierbei ist eine Veredelung der Aluminium-Chip-Pads auf Waferebene vorteilhaft.
- Die Verbindung kann auch durch Einsatz von vorgeformten Presswerkzeugen in handelsüblichen Pressen erfolgen.
- Die leitfähigen Metallstrukturen können durch einen Druckprozess aufgebracht werden.

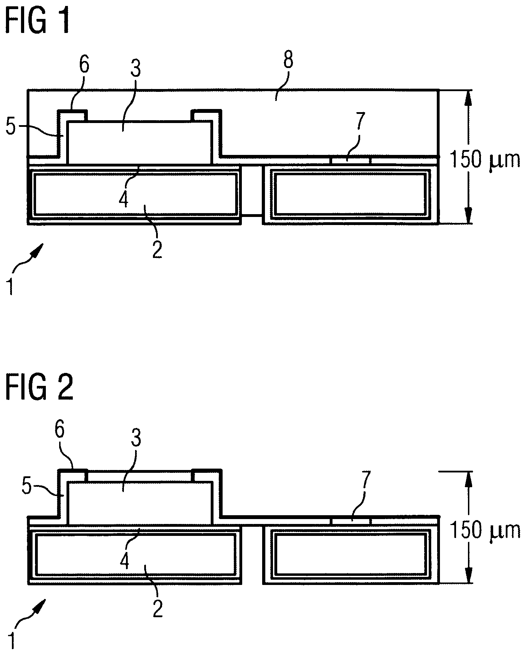

In Figur 1 erkennt man ein Erzeugnis 1 aufweisend ein Substrat 2 in Form eines geätzten Kupfer-Leadframes. Das Kupfer des Leadframes ist dabei mit einer Nickel-Gold-Galvanik umgeben, um die Löteigenschaften zu verbessern. Auf dem Substrat 2 ist ein optoelektronisches Bauelement 3 in Form eines Chips angeordnet und mit dem Substrat 2 über Leitkleber oder Lot 4 elektrisch und mechanisch verbunden.

Über das Substrat 2 und das optoelektronische Bauelement 3 ist eine isolierende Schicht 5 in Form einer Folie geführt. Die isolierende Schicht 5 ist im Bereich der Lichtaustrittsöffnung des optoelektronischen Bauelements 3 durch ein Fenster geöffnet. Zur Kontaktierung des optoelektronischen Bauelements 3 ist eine planare Leitstruktur 6 in Form einer Metallisierung über die isolierende Schicht 5 zu Kontaktstellen des optoelektronischen Bauelements 3 und zu einer Leiterbahn 7 des Substrats 2 geführt.

Das Substrat 2 mit dem optoelektronischen Bauelement 3, der isolierenden Schicht 5 und der planaren Leitstruktur 6 sind in eine Schutzmasse 8 in Form eines Clear-Mold-Compounds eingegossen. Das Erzeugnis 1 ist etwa 150 µm hoch.

Das in Figur 2 dargestellte nicht erfindungsgemäße Erzeugnis 1 entspricht dem in Figur 1 dargestellten mit Ausnahme der Tatsache, dass die isolierende Schicht 5 transparent ausgeführt ist und deshalb im Bereich der Lichtaustrittsöffnung des optoelektronischen Bauelements 3 durchläuft. Es ist dort also kein Fenster geöffnet, sondern nur an den Kontaktstellen des optoelektronischen Bauelements 3, an denen dieses mit der planaren Leitstruktur 6 elektrisch verbunden ist. Die transparente, isolierende Schicht 5 kann insbesondere im Bereich der Lichtaustrittsöffnung des optoelektronischen Bauelements 3 Pigmente enthalten, um austretendes Licht zu färben.

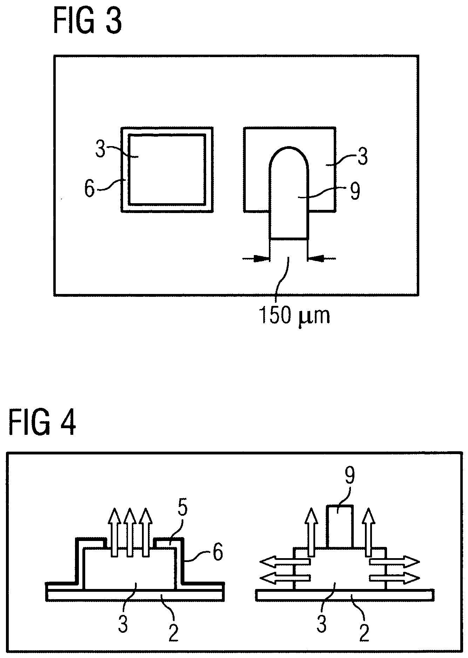

In Figur 3 erkennt man links ein planar kontaktiertes optoelektronisches Bauelement 3 mit einem großen zentralen Lichtaustritt und einer diesen Lichtaustritt vollkommen umgebenden Randkontaktierung mit einer planaren Leitstruktur 6 und einer darunter verborgenen isolierenden Schicht. Alternativ kann die Randkontaktierung je nach Aufbau der Kontaktstellen des optoelektronischen Bauelements 3 und beabsichtigter Lichtführung auch nicht vollständig umlaufend, sondern nur an einer oder mehreren einzelnen Stellen zur dem Substrat 2 abgewandten Stirnseite des optoelektronischen Bauelements 3 laufen.

Rechts sieht man in Figur 3 ein optoelektronisches Bauelement 3, das nach dem Stand der Technik über 120 µm-Drahtbonden mit einem Draht 9 kontaktiert ist. Wie man erkennt, wird ein Großteil der Lichtaustrittsöffnung des optoelektronischen Bauelements 3 verdeckt.

Die Vorteile der planaren Kontaktierung bei der Lichtführung werden in Figur 4 besonders deutlich. Hier sieht man links wiederum das planar durch die isolierende Schicht 5 und die planare Leitstruktur 6 kontaktierte optoelektronische Bauelement 3 auf dem Substrat 2. Alle Lichtaustrittsöffnungen des optoelektronischen Bauelements 3, an denen ein Lichtaustritt nicht gewünscht wird, werden durch die isolierende Folie 5 und die planare Leitstruktur 6 verdeckt. Weil diese reflektierend ausgeführt sind, wird das Licht in das optoelektronische Bauelement 3 zurückreflektiert, bis es an der vorgesehenen Lichtaustrittsöffnung austritt.

Bei der rechts in Figur 4 dargestellten Kontaktierung nach dem Stand der Technik wird dagegen ein großer Teil des gewünschten Lichtaustrittsbereichs durch den angebondeten Draht 9 verdeckt. Stattdessen tritt das Licht ungewünscht parallel zum Substrat 2 aus den Seiten des optoelektronischen Bauelements 3 aus.

Beim planar kontaktierten optoelektronischen Bauelement 3 tritt das Licht dagegen wie gewünscht an der dem Substrat 2 gegenüber liegenden Stirnfläche des optoelektronischen Bauelements 3 und damit in etwa senkrecht zum Substrat 2 aus.

Die beschriebene Aufbau- und Verbindungstechnik weist folgende Vorteile auf:
- Kleinflächige Ankontaktierung und ein variables Layout ermöglichen größtmögliche Lichtausbeuten.
- Homogene Stromverteilung durch ausgewählte Kontaktleiterdimensionen mit der Folge einer hohen Lichtausbeute.
- Ultradünner, miniaturisierter Aufbau.
- Planare Ankontaktierung ermöglicht dünne Moldmassenabdeckung.
- Planare Ankontaktierung ermöglicht eine effektive Entwärmung durch einen flächig angebrachten Kühlkörper
- Kostengünstige Aufbau- und Verbindungstechnik durch hochparallele Prozessierung (Prozessierung im Nutzen). Auch das Fertigen im Reel-to-Reel-Verfahren ist möglich.
- Keine Abschattung durch zentrale Wirebond-Pads in der Chipmitte.
- Hohe Zuverlässigkeit durch angepasste Materialeigenschaften, zum Beispiel CTE (Coeffizient of Thermal Expansion), Tg (Temperatur des Glasübergangs) usw.
- Bei geeigneter Wahl der optischen Eigenschaften der Isolierfolie kann diese die Schutzfunktion des Clear-Mold-Compounds mit übernehmen, so dass dieser nicht mehr notwendig ist.
- Die Leuchtstoffe für die Lichtkonversion blau zu weiß können als Pigmente in die Folie eingearbeitet werden. Auf diese Weise ist über eine genau bestimmte Foliendicke und Pigmentkonzentration in der Folie eine gute Steuerung der Farbkoordinaten möglich.

## Patentansprüche

1. Erzeugnis aufweisend ein Substrat (2) mit einem darauf angeordneten optoelektronischen Bauelement (3), das mittels einer planaren Leitstruktur (6) elektrisch kontaktiert ist,
wobei
- das Substrat (2) und das optoelektronische Bauelement (3) zumindest teilweise mit einer elektrisch isolierenden Schicht (5) versehen sind, die durch eine Folie, Lack oder eine Polymerschicht gebildet ist,
- in der isolierenden Schicht (5) im Bereich einer Lichtaus- und/oder -eintrittsöffnung des optoelektronischen Bauelements (3) ein Fenster geöffnet ist,
- zur Kontaktierung des optoelektronischen Bauelements (3) die planare Leitstruktur (6) in Form einer Metallisierung über die isolierende Schicht (5) zu Kontaktstellen des optoelektronischen Bauelements (3) und zu einer Leiterbahn (7) des Substrats (2) geführt ist, und
- die planare Leitstruktur (6) reflektierend ausgeführt ist,
**dadurch gekennzeichnet, dass**
- die elektrisch isolierende Schicht (5)reflektierend ausgeführt ist, sodass alle Lichtaustrittsöffnungen des optoelektronischen Bauelements, an denen ein Lichtsaustritt nicht gewünscht ist, durch die reflektierend ausgeführte elektrisch isolierende Schicht (5) und die planare reflektierend ausgeführte Leitstruktur (6) verdeckt sind, sodass das Erzeugnis derart ausgestaltet ist, dass Licht an den nicht gewünschten Lichtaustrittsöffnungen in das optoelektronische Bauelement (3) zurückreflektiert wird, und
- das Bauelement (3) in Form eines Chips mit dem Substrat (2) über einen Leitkleber oder ein Lot elektrisch und mechanisch verbunden ist.

2. Erzeugnis nach Anspruch 1,
**dadurch gekennzeichnet,**
**dass** das optoelektronische Bauelement (3) mit der Leiterbahn (7) planar kontaktiert ist.

3. Erzeugnis nach einem der vorhergehenden Ansprüche, **dadurch gekennzeichnet, dass**
das Bauelement im Bereich der Lichtaus- und/oder - eintrittsöffnung einen zentralen Lichtaustritt aufweist, der von einer durch die planare Leitstruktur (6) gebildeten Randkontaktierung vollkommen umgeben ist.

4. Erzeugnis nach einem der vorhergehenden Ansprüche, **dadurch gekennzeichnet,**
**dass** die planare Leitstruktur (6) eine Kupferschicht ist.

5. Erzeugnis nach einem der vorhergehenden Ansprüche, **dadurch gekennzeichnet,**
**dass** die isolierende Schicht (5) im Bereich einer der Kontaktstellen des optoelektronischen Bauelements (3) durch das Fenster geöffnet ist, durch das die planare Leitstruktur (6) zur Kontaktstelle des optoelektronischen Bauelements geführt ist.

6. Erzeugnis nach einem der vorhergehenden Ansprüche, **dadurch gekennzeichnet,**
**dass** das optoelektronische Bauelement (3) eine LED, insbesondere eine OLED, und/oder ein fotovoltaisches Bauelement ist.

7. Erzeugnis nach einem der vorhergehenden Ansprüche, **dadurch gekennzeichnet,**
**dass** das Substrat (2) eine Leiterplatte, eine Flex oder ein Leadframe ist.

8. Erzeugnis nach einem der vorhergehenden Ansprüche, **dadurch gekennzeichnet,**
**dass** die Höhe des Erzeugnisses (1) weniger als 0,4 mm beträgt.

9. Verfahren zum Herstellen eines Erzeugnisses (1) aufweisend ein Substrat (2) mit einem darauf angeordneten optoelektronischen Bauelement (3), wobei das optoelektronische Bauelement (3) mittels einer planaren Leitstruktur (6) elektrisch kontaktiert wird, indem
- das Substrat (2) und das optoelektronische Bauelement (3) zumindest teilweise mit einer elektrisch isolierenden Schicht (5) versehen werden, wobei die isolierende Schicht (5) im Bereich einer Lichtaus- und/oder -eintrittsöffnung des optoelektronischen Bauelements (3) ein Fenster aufweist,
- zur Bildung der isolierenden Schicht (5) eine elektrisch isolierende Folie auf das optoelektronische Bauelement (3) auflaminiert wird,
- die planare Leitstruktur (6) in Form einer Metallstruktur auf die elektrisch isolierende Folie aufgebracht wird, wobei zur Kontaktierung des optoelektronischen Bauelements (3) die planare Leitstruktur (6) in Form einer Metallisierung über die isolierende Schicht (5) zu Kontaktstellen des optoelektronischen Bauelements (3) und zu einer Leiterbahn (7) des Substrats (2) geführt ist, und
- die planare Leitstruktur (6) reflektierend ausgeführt ist,
**dadurch gekennzeichnet, dass**
- die elektrisch isolierende Schicht (5) reflektierend ausgeführt ist, sodass alle Lichtaustrittsöffnungen des optoelektronischen Bauelements, an denen ein Lichtsaustritt nicht gewünscht ist, durch die reflektierend ausgeführte elektrisch isolierende Schicht (5) und die reflektierend ausgeführte planare Leitstruktur (6) verdeckt werden, sodass das Erzeugnis derart ausgestaltet ist, dass Licht an den nicht gewünschten Lichtaustrittsöffnungen in das optoelektronische Bauelement (3) zurückreflektiert wird, und
- das Bauelement (3) in Form eines Chips mit dem Substrat (2) über einen Leitkleber oder ein Lot elektrisch und mechanisch verbunden wird.

10. Verfahren nach Anspruch 9, **dadurch gekennzeichnet,**
**dass** zur Ausbildung der planaren Leitstruktur (6) die isolierende Schicht (5) durch Aufkaschieren einer strukturierten Metallfolie elektrisch leitfähig beschichtet wird, wobei die Metallfolie vor dem Laminierprozess strukturiert wird.

11. Verfahren nach einem der Ansprüche 9 oder 10, **dadurch gekennzeichnet,**
**dass** das Fenster in der isolierenden Schicht (5) vor Aufbringen der isolierenden Schicht (5) ausgebildet wird.

12. Verfahren nach einem der Ansprüche 9 oder 10, **dadurch gekennzeichnet,**
**dass** das Fenster in der isolierenden Schicht (5) nach Aufbringen der isolierenden Schicht (5) ausgebildet wird.

13. Verfahren nach einem der Ansprüche 9 bis 12, **dadurch gekennzeichnet,**
**dass** das Fenster in der isolierenden Schicht (5) mittels Laser, (Plasma-)Ätzen, Inkjet und/oder Fotostrukturierung ausgebildet wird.

## Claims

1. A product having a substrate (2) with an optoelectronic component (3) arranged thereon, which is electrically contacted by means of a planar conducting structure (6), wherein
- the substrate (2) and the optoelectronic component (3) are at least partially provided with an electrically insulating layer (5) which is formed by a foil, lacquer or polymer layer,
- a window is opened in the insulating layer (5) in the region of a light exit and/or entry opening of the optoelectronic component (3),
- for contacting the optoelectronic component (3), the planar conducting structure (6) in the form of a metallization is guided over the insulating layer (5) to contact points of the optoelectronic component (3) and to a conductor track (7) of the substrate (2), and
- the planar conducting structure (6) is formed to be reflective,
**characterized in that**
- the electrically insulating layer (5) is formed to be reflective such that all light exit openings of the optoelectronic component at which light exit is not desired are covered by the reflective electrically insulating layer (5) and the planar reflective conducting structure (6) such that the product is formed that light is reflected back into the optoelectronic component (3) at the undesired light exit openings, and
- the component (3) in the form of a chip is electrically and mechanically connected to the substrate (2) by a conductive adhesive or a solder.

2. The product according to claim 1,
**characterized in that**
the optoelectronic component (3) is in planar contact with the conductor track (7).

3. The product according to one of the preceding claims, **characterized in that**
in the region of the light exit and/or entry opening, the component has a central light exit which is completely surrounded by a boundary contact formed by the planar conducting structure (6).

4. The product obtained from one of the preceding claims, **characterized in that**
the planar conducting structure (6) is a copper layer.

5. The product according to one of the preceding claims, **characterized in that**
the insulating layer (5) is opened in the region of one of the contact points of the optoelectronic component (3) through the window through which the planar conducting structure (6) is guided to the contact point of the optoelectronic component.

6. The product according to one of the preceding claims, **characterized in that**
the optoelectronic component (3) is an LED, in particular an OLED, and/or a photovoltaic component.

7. The product according to one of the preceding claims, **characterized in that**
the substrate (2) is a printed circuit board, a flex or a lead-frame.

8. The product according to one of the preceding claims, **characterized in that**
the height of the product (1) is less than 0.4 mm.

9. A method for producing a product (1) having a substrate (2) with an optoelectronic component (3) arranged thereon, wherein the optoelectronic component (3) is electrically contacted by means of a planar conducting structure (6), in which
- the substrate (2) and the optoelectronic component (3) are provided at least partially with an electrically insulating layer (5), wherein the insulating layer (5) has a window in the region of a light exit and/or entry opening of the optoelectronic component (3),
- an electrically insulating foil is laminated onto the optoelectronic component (3) to form the insulating layer (5),
- the planar conducting structure (6) in the form of a metal structure is applied to the electrically insulating foil, wherein for contacting the optoelectronic component (3), the planar conducting structure (6) in the form of a metallization is guided over the insulating layer (5) to contact points of the optoelectronic component (3) and to a conductor track (7) of the substrate (2), and
- the planar conducting structure (6) is formed to be reflective,
**characterized in that**
- the electrically insulating layer (5) is formed to be reflective so that all light exit openings of the optoelectronic component at which light exit is not desired are covered by the reflective electrically insulating layer (5) and the reflective planar conducting structure (6) so that the product is formed such that light is reflected back into the optoelectronic component (3) at the undesired light exit openings, and
- the component (3) in the form of a chip is electrically and mechanically connected to the substrate (2) by a conductive adhesive or a solder.

10. The method according to claim 9,
**characterized in that**
for forming the planar conducting structure (6), the insulating layer (5) is electrically conductively coated by laminating a structured metal foil, wherein prior to the lamination process, the metal foil is structured.

11. The method according to one of claims 9 or 10,
**characterized in that**
before applying the insulating layer (5), the window is formed in the insulating layer (5).

12. The method according to one of claims 9 or 10,
**characterized in that**
after applying the insulating layer (5), the window is formed in the insulating layer (5).

13. The method according to one of claims 9 to 12,
**characterized in that**
the window is formed in the insulating layer (5) by means of laser, (plasma) etching, inkjet and/or photo-structuring.

## Revendications

1. Produit comprenant un substrat (2) sur lequel est disposé un composant optoélectronique (3) à contact électrique grâce à une structure de guidage planaire (6), dans lequel
- le substrat (2) et le composant optoélectronique (3) sont pourvus au moins partiellement d'une couche électriquement isolante (5) constituée par un film, du vernis ou une couche polymère,
- au droit d'une ouverture d'entrée et/ou de sortie de lumière du composant optoélectronique (3), une fenêtre est ouverte dans la couche isolante (5),
- pour le contact du composant optoélectronique (3), la structure de guidage planaire (6), sous forme d'une métallisation, est amenée en passant par la couche isolante (5), vers des points de contact du composant optoélectronique (3) et vers une piste conductrice (7) du substrat (2), et
- la structure de guidage planaire (6) est conçue de manière réfléchissante,
**caractérisé en ce que**
- la couche électriquement isolée (5) est réalisée sous forme réfléchissante de manière que l'ensemble des ouvertures de sortie de lumière du composant optoélectronique sur lesquelles une sortie de lumière n'est pas désirée est masqué grâce à la couche électriquement isolante (5) et à la structure de guidage (6) planaire conçue sous forme réfléchissante, de manière que le produit se présente de façon qu'aux ouvertures de sortie de lumière non désirées, la lumière est reflétée de retour dans le composant optoélectronique (3), et
- le composant (3) est relié électriquement et mécaniquement au substrat sous forme d'une puce (2) à l'aide d'une colle conductrice ou d'une brasure.

2. Produit selon la revendication 1,
**caractérisé en ce que**
le composant optoélectronique (3) est mis en contact avec la piste conductrice (7) de manière plane.

3. Produit selon l'une quelconque des revendications précédentes,
**caractérisé en ce que**
le composant présente, au droit de l'ouverture de sortie et/ou d'entrée une sortie de lumière centrale qui est entièrement entourée d'un contact de bord constitué par la structure de guidage planaire (6).

4. Produit selon l'une quelconque des revendications précédentes,
**caractérisé en ce que**
la structure de guidage planaire (6) est une couche en cuivre.

5. Produit selon l'une quelconque des revendications précédentes,
**caractérisé en ce que**
la couche électriquement isolante (5) est ouverte, au droit d'un des points de contact du composant optoélectronique (3) par la fenêtre à travers de laquelle la structure de guidage planaire (6) est amenée vers le point de contact du composant optoélectronique.

6. Produit selon l'une quelconque des revendications précédentes,
**caractérisé en ce que**
le composant optoélectronique (3) est une LED, notamment une OLED et/ou un composant photovoltaïque.

7. Produit selon l'une quelconque des revendications précédentes,
**caractérisé en ce que**
le substrat (2) est soit une carte de circuit imprimé, une carte flexible ou un cadre métallique.

8. Produit selon l'une quelconque des revendications précédentes,
**caractérisé en ce que**
la hauteur du produit (1) est inférieure à 0,4 mm.

9. Procédé de fabrication d'un produit (1) comprenant un substrat (2) sur lequel est agencé un composant optoélectronique (3), le composant optoélectronique (3) étant mis en contact électriquement à l'aide d'une structure de guidage planaire (6),
- le substrat (2) et le composant optoélectronique (3) étant équipés au moins partiellement d'une couche électriquement isolante (5), la couche isolante (5) présentant une fenêtre au droit d'une ouverture d'entrée et/ou de sortie de lumière du composant optoélectronique (3),
- pour constituer la couche isolante (5), un film électriquement isolant est laminé sur le composant optoélectronique (3),
- la structure de guidage planaire (6) est appliquée sous forme d'une structure métallique sur le film électriquement isolant, le contact du composant optoélectronique (3) étant assuré par un guidage de la structure de guidage planaire (6) sous forme d'une métallisation, en passant par la couche isolante (5), vers des points de contact du composant optoélectronique (3) et vers une piste conductrice (7) du substrat (2), et
- la structure de guidage planaire (6) est conçue de manière réfléchissante,
**caractérisé en ce que**
- la couche électriquement isolante (5) est réalisée de manière réfléchissante de sorte que l'ensemble des ouvertures de sortie de lumière du composant optoélectronique sur lesquelles une sortie de lumière n'est pas désirée est masqué grâce à la couche électriquement isolante (5) et à la structure de guidage planaire (6) conçue de manière réfléchissante, de sorte que le produit se présente de façon qu'aux ouvertures de sortie de lumière non désirées, la lumière est reflétée de retour dans le composant optoélectronique (3), et
- le composant (3) est relié électriquement et mécaniquement au substrat sous forme d'une puce (2) à l'aide d'une colle conductrice ou d'une brasure.

10. Procédé selon la revendication 9,
**caractérisé en ce que**,
pour constituer la structure de guidage planaire (6), la couche isolante (5) reçoit un revêtement électriquement conducteur par laminage d'un film métallique structuré, la structuration du film métallique se faisant préalablement au processus de laminage.

11. Procédé selon l'une des revendications 9 ou 10, **caractérisé en ce que**
la fenêtre prévue dans la couche isolante (5) est ménagée avant le dépôt de la couche isolante (5).

12. Procédé selon l'une des revendications 9 ou 10, **caractérisé en ce que**
la fenêtre prévue dans la couche isolante (5) est ménagée après le dépôt de la couche isolante (5).

13. Procédé selon l'une des revendications 9 à 12,
**caractérisé en ce que**
la fenêtre prévue dans la couche isolante (5) est obtenue par laser, gravure (au plasma), jet d'encre et/ou par photo-structuration.
